# EUROPEAN PATENT APPLICATION

(11) **EP 3 540 002 A1**
(43) Date of publication of application: **18.09.2019**
(21) Application number: 19162345.3
(22) Date of filing: 12.03.2019
(51) Int. Cl.: C08J 7/06, C08J 5/04, B64D 13/06

(54) **OXYGEN BARRIER FOR COMPOSITES**

(30) Priority: 16.03.2018 US 201815923149
(71) Applicant: Hamilton Sundstrand Corporation, Charlotte, NC 28217-4578 (US)
(72) Inventor: POTEET, Steven, 06518, Connecticut Hamden (US); FOLSOM, Michael E., Ellingtom, Connecticut 06029 (US); SHEEDY, Paul, Bolton, Connecticut 06043 (US); MAGDEFRAU, Neal, Tolland, Connecticut 06084 (US)
(74) Representative: Dehns

(57) **Abstract**

A composite article may include a matrix comprising a carbon-containing resin-based filler material, a reinforcing phase, and an oxidation barrier coating formed by atomic layer deposition. In an embodiment, a method of forming a composite article resistant to oxidation comprises forming the composite article and forming an oxidation barrier on the surface of the article by atomic layer deposition.

## Description

### BACKGROUND

The present disclosure relates in general to aircraft environmental control systems (ECS). In particular, the present disclosure relates to a service lifetime of composite ductwork in ECS structures.

Aircraft are provided with environmental control systems. An environmental control system may include ram air cooled heat exchangers and air conditioning packs to supply conditioned air to an aircraft cabin.

Ductwork in the environmental control system is preferably formed from a lightweight fiber-reinforced matrix composite material such as glass or carbon fiber reinforced epoxy matrix material. Composite materials of this type are susceptible to fiber/matrix interface degradation due to oxygen diffusion at temperatures in the range of a few hundred degrees Fahrenheit causing oxidation, premature cracking, and brittleness leading to component failure.

### SUMMARY

A composite article may include a matrix comprising a carbon-containing resin-based filler material, a reinforcing phase, and an oxidation barrier coating formed by atomic layer deposition.

In an embodiment, a method of forming a composite article resistant to oxidation comprises forming the composite article and forming an oxidation barrier on the surface of the article by atomic layer deposition.

### BRIEF DESCRIPTION OF THE DRAWINGS

FIG. 1 is a schematic diagram of an aircraft environmental control system.
FIG. 2 is a photograph of a composite duct in an aircraft environmental cooling system.
FIG. 3 is a schematic illustration of an atomic layer deposition process.

### DETAILED DESCRIPTION

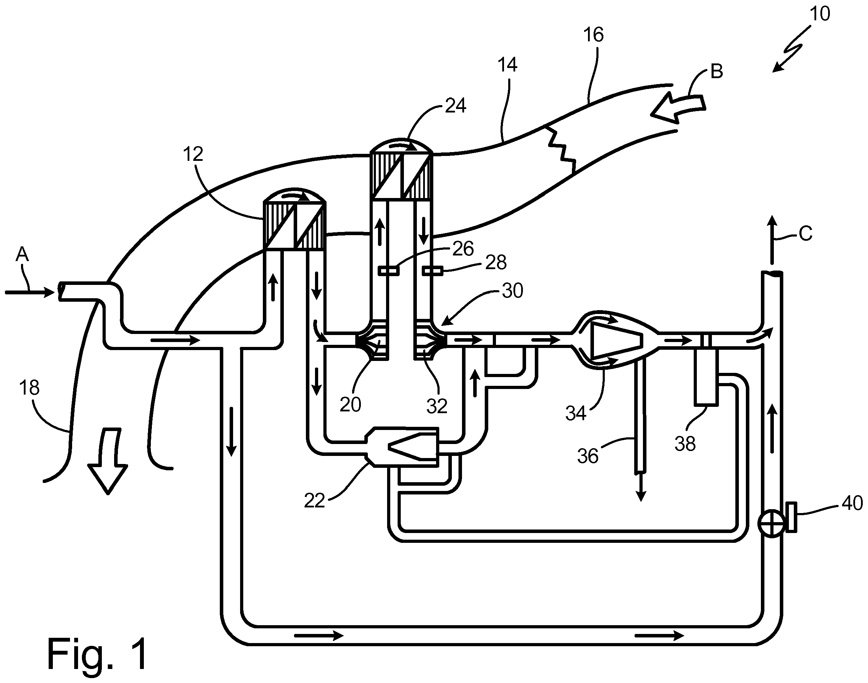

Aircraft are provided with environmental control systems that provide a temperature controlled comfortable environment for passengers in a cabin of the aircraft. A schematic diagram of an aircraft environmental control system is shown in FIG. 1. In order to control the cabin environment, environmental control system (ECS) 10 utilizes compressed heated air from an engine or auxiliary power unit (APU) that enters ECS 10 from a flow control valve (not shown) as indicated by arrow A. The incoming compressed heated air is cooled by ram air passing through primary heat exchanger 12 situated in ram air duct 14 between ram air inlet duct 16 and ram air exhaust duct 18. Ram air entering ram air inlet duct 16 is indicated by arrow B.

A portion of the incoming hot compressed air is directed to cabin control valve 40 for subsequent mixing with treated air exiting air cycle machine 30. Air bypassing compressor 20 from primary heat exchanger 12 enters water separator-temperature control valve 22 where the amount of bypass air entering water separator 30 from primary heat exchanger 12 is controlled before it enters water separator 22 and is dried.

A portion of the cooled compressed air exiting primary heat exchanger 12 is further compressed and heated again by compressor 20. Air compressed by compressor 20 passes through secondary heat exchanger 24 where it is cooled again by ram air in duct 14. Compressor discharge temperature sensor 26 and turbine inlet temperature sensor 28 monitor the temperature of the air exiting compressor 20 and secondary heat exchanger 24. Heated air exiting turbine 32 and air cycle machine 30 is expanded and cooled further. As mentioned, the portion of cooled compressed air from primary heat exchanger 12 that does not enter compressor 20 passes through water separator 34 and is dried.

The cooled air leaving air cycle machine 30 enters water separator 34 with water separator drain line 36 and is dried. Thermostat 38 controls the mixture of cooled dry air leaving air cycle machine 30. Control valve 40 controls the amount of heated compressed air from the engine that is mixed with cooled dry air from air cycle machine 30 that enters a mixing chamber where the air is mixed with cabin air to maintain a preferred cabin environment as indicated by arrow C.

Most of the ductwork exposed to high temperatures in aircraft environmental control systems is formed from high temperature resistant polymer matrix composite materials containing strengthening reinforcing materials comprised of fibers, particles, fabrics and mixtures thereof.

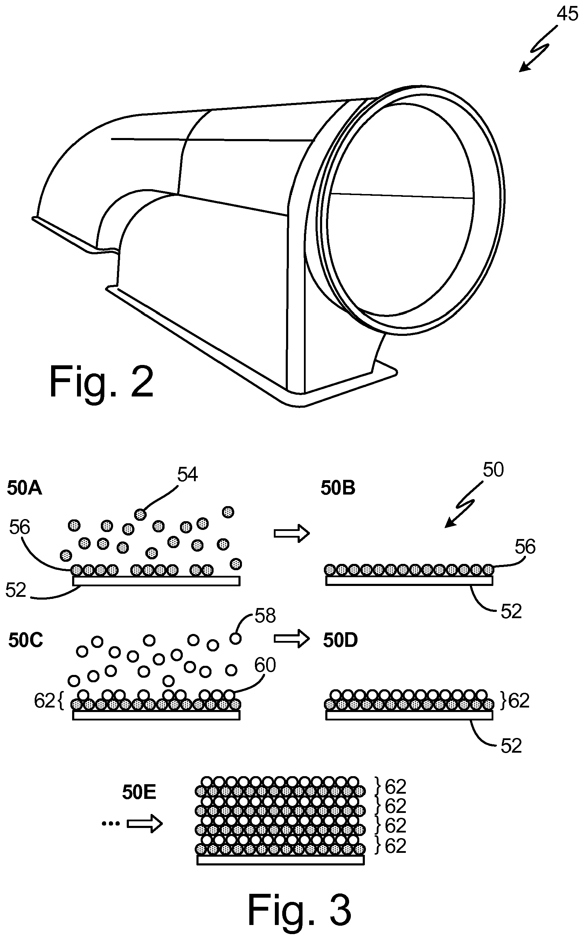

An example of a fiber reinforced composite duct in an aircraft ECS is shown in FIG. 2. In one example, the diameter of the circular intake of duct 45 is approximately 0.6 m, and the length of duct 45 is approximately 1.5 m. Duct 45 functions as a ram air intake duct in the ECS. Fibers in suitable composites that form duct 45 may be in the form of single fibers, tows, and/or woven fabrics. Suitable fiber materials include carbon, graphite, glass, aramid, polymer, ceramics or mixtures thereof. Suitable polymer matrix materials may include, but are not limited to thermoset and thermoplastic polymers. Thermoset polymer matrices may include bis-malemide, cyanate esters, epoxies, phenolics, polyesters, polyimides, polyurethanes, silicones, vinyl esters or mixtures thereof. Thermoplastic polymer matrices may include but are not limited to polyetherimides, polyamide imides, polyphenylene sulfides, polycarbonates, polyetheretherketones or mixtures thereof.

The basic steps in formation of a polymer matrix composite (PMC) include impregnation of the fiber with the resin, forming the structure, curing (thermoset matrices) or thermal processing (thermoplastic matrices), and finishing.

Depending on the process, these steps may occur separately or continuously. A starting material for many PMCs is prepreg where fiber tape or cloth that has been pre-impregnated with resin is partially cured. In pultrusion, by contrast, impregnation, forming, and curing are carried out in a single continuous process. Some important fabrication processes for PMCs include resin transfer molding, prepreg tape layup, pultrusion, and filament winding.

Oxygen barrier coatings on fiber reinforced polymer matrix composite materials formed by direct spray or vapor phase deposition may improve oxidation protection at elevated temperatures during service.

One purpose of the present disclosure is to protect fiber reinforced polymer composite materials from oxygen ingress and the resulting oxidation at temperatures greater than normal oxidation temperatures of unprotected polymers including temperatures up to 600°F (316°C). This is accomplished by depositing oxygen barrier layers on internal and external surfaces of the composite material of the duct by atomic layer deposition (ALD). Example oxygen barrier layers may include but are not limited to stoichiometric and non-stoichiometric oxide, nitride, and oxynitride barrier layers, as well as metallic barrier layers. Example oxide oxygen barrier layers may include but are not limited to, Al₂O₃, CeO₂, MgO, NiO, TiO₂, V₂O₅, ZrO₂ or mixtures thereof. Example nitride oxygen barrier layers may include AlN, HfN, InN, MgN, NbN, SiN, TaN, TiN, ZrN or mixtures thereof. Example oxynitride barrier layers include silicon oxynitride, SiOₓN_{y}, aluminum oxynitride, (AlN)ₓ · (Al₂O₃)₁₋ₓ, or mixtures thereof. In embodiments, oxygen barrier layers may be multilayer composites of different ceramic and metallic components. The oxygen barrier coatings may be single material layers, single material multilayers, or multimaterial multilayers.

The ALD process used to deposit oxygen barrier layers on internal and external surfaces of the composite material of the duct is similar to other vapor deposition processes such as chemical vapor deposition (CVD), except that the ALD reaction breaks the CVD reaction into two half reactions wherein the precursor materials are separated during the deposition process. ALD film growth is self-limiting and based on surface reactions which allow for atomic scale control. By keeping the precursors separate throughout the coating process, atomic layer thickness control can be limited to the angstrom or single or multiple molecular layer control in each step of the process as a result of the self-limiting feature of ALD. The self-limiting feature of ALD leads to excellent step coverage and conformal deposition on high aspect ratio structures such as fiber reinforced composite materials. In addition, the reactions are driven to completion during each reaction cycle. As a result, the films are extremely smooth, continuous, and pinhole free. Since the ALD precursors are gas phase molecules, they fill all space independent of substrate geometry and do not require line of sight to a substrate during deposition. Most ALD processes are based on binary reaction sequences where two reaction sequences occur during two sequential events to produce a binary compound film.

As an example, ALD deposition process 50 illustrated in FIG. 3 will be described. In step 50A, substrate 52 is provided and exposed to a precursor gas molecule 54 of the compound to be formed. At this step, the substrate is in an isolated chamber (not shown). Precursor molecules 54 of the precursor gas react with substrate 52 and are attached to substrate 52 as molecules 56. Attachment may be by chemisorption or a surface chemical reaction process. In the aluminum oxide sample of FIG. 3, precursor gas molecules 54 may be water molecules and the species may be hydroxyl molecules (OH⁻) 56 which saturate the surface of substrate 52 and form a monolayer of hydroxide molecules remaining on the surface as shown in step 50B. In the next step, the substrate chamber is purged with flowing inert gas.

In the next step substrate 52 is exposed to an aluminum oxide precursor gas 58 at a specified reaction temperature that reacts with adsorbed hydroxyl groups 56 to form aluminum oxide 62 and methane gas, CH₄ (not shown), as shown in step 50C. The precursor reactive gas 58 in this example is trimethyl aluminum, Al(CH₃)₃. The reaction between trimethyl aluminum 58 and the adsorbed hydroxyl ions 56 continues until the surface is passivated and is completely covered with a layer of aluminum oxide 62 as shown in step 50D.

In the next step, the chamber is cooled and purged with flowing inert gas to remove gaseous reaction products in preparation for the next deposition cycle which, in this case, is exposure of layer 62 on substrate 52 to water vapor. The process is repeated by purging the substrate with flowing inert gas and exposing the adsorbed hydroxyl ion saturated surface to trimethyl aluminum to form an aluminum oxide layer on the original aluminum oxide layer. The chamber is then purged with inert gases and the process repeated until an aluminum oxide surface layer with a thickness sufficient to block oxygen ingress at high temperatures is formed as shown in step 50E of FIG. 3.

To examine the effectiveness of an aluminum oxide film deposited by ALD against oxidation, 1018 steel coupons were coated with a 300nm Al₂O₃ film and exposed to an oxidizing atmosphere of air at 500°C for times up to 1000 hours at 500°C in air. Uncoated coupons were heavily coated with rust and were visibly larger. Coated coupons exhibited no apparent change in appearance as a result of the oxidizing treatment.

### DISCUSSION OF POSSIBLE EMBODIMENTS

The following are non-exclusive descriptions of possible embodiments of the present invention.

A composite article includes a matrix comprising a carbon-containing resin-based material, a reinforcing phase, and oxidation barrier coating formed by atomic layer deposition.

The composite article of the preceding paragraph can optionally include, additionally and/or alternatively, any one or more of the following features, configurations, and/or additional components:

The carbon-containing resin-based material may be a polymer.

The oxidation barrier coating may protect the polymer from temperatures greater than normal oxidation temperatures of unprotected polymers.

The oxidation barrier coating may protect the polymer from oxidation at temperatures up to 600°F (316°C).

The polymer may be selected from the group consisting of thermoset polymers and thermoplastic polymers.

The reinforcing phase may comprise fibers selected from the group consisting of carbon, graphite, glass, aramid, polymer, ceramics, and mixtures thereof.

The oxygen barrier coating may be a single material multilayer or a multimaterial multilayer.

The oxygen barrier coating may be oxides, nitrides, oxynitrides, metals or mixtures thereof.

The oxygen barrier coating may be oxides selected from the group consisting of Al₂O₃, CeO₂, MgO, NiO, TiO₂, V₂O₅, ZrO₂ and mixtures thereof, and/or nitrides selected from the group consisting of AlN, HfN, InN, MgN, NbN, SiN, TaN, TiN, ZrN and mixtures thereof, and/or oxynitrides selected from the group consisting of silicon oxynitrides, (SiOₓN_{y}), aluminum oxynitride, (AlN)ₓ • (Al₂O₃)₁₋ₓ, and mixtures thereof.

A method of forming a composite article may include forming a composite material, shaping the composite material into a shape of the composite article, and forming an oxidation barrier on the surface of the composite article by atomic layer deposition.

The method of the preceding paragraph can optionally include, additionally and/or alternatively, any one or more of the following features, configurations and/or additional components:

The composite material may be a fiber-reinforced polymer matrix material.

Shaping the composite material into a shape of the composite article may include sheet molding, resin transfer molding, prepreg layup, pulltrusion, filament winding, or mixtures thereof.

Fibers of the fiber-reinforced polymer matrix material may be selected from the group consisting of carbon, graphite, glass, aramid, polymer, ceramics, and mixtures thereof.

The polymer matrix may be selected from the group consisting of thermoset polymers, thermoplastic polymers, and mixtures thereof.

The polymer matrix may be thermoset polymers selected from the group consisting of bis-malemide, cyanate esters, epoxies, phenolics, polyesters, polyimides, polyurethanes, silicones, vinyl esters, and mixtures thereof.

The polymer matrix may be thermoplastic polymers selected from the group consisting of polyetherimide, polyamide imides, polyphenylene sulfides, polycarbonates, polyethertherketones and mixtures thereof.

The oxidation barrier may be single material layers or multimaterial layers of materials selected from the group consisting of oxides, nitrides, oxynitrides, metals and mixtures thereof.

The shape of the composite article may be ram intake manifolds, ram air exhaust manifolds, ductwork, mixing chambers, and other fluid management devices.

The shape of the composite article may be one or more components in aircraft environmental control systems.

## Claims

1. A composite article comprising:
a matrix material comprising a carbon-containing resin-based material;
a reinforcing phase; and
an oxidation barrier coating formed by atomic layer deposition.

2. The composite article of claim 1, wherein the carbon-containing resin-based material comprises a polymer.

3. The composite article of claim 1 or 2, wherein the oxidation barrier coating protects the polymer from temperatures greater than normal oxidation temperatures of unprotected polymers, and preferably wherein the oxidation barrier coating protects the polymer from oxidation at temperatures up to 600°F (316°C).

4. The composite article of any preceding claim, wherein the polymer is selected from the group consisting of thermoset polymers, thermoplastic polymers, and mixtures thereof, and preferably wherein the reinforcing phase comprises fibers selected from the group consisting of carbon, graphite, glass, aramid, polymer, ceramics, and mixtures thereof, and preferably

5. The composite material of any preceding claim, wherein the oxygen barrier coating comprises a single material layer, a single material multilayer, or multimaterial multilayer.

6. The composite article of any preceding claim, wherein the oxidation barrier coating comprises oxides, nitrides, oxynitrides, metals, or mixtures thereof, and preferably wherein the oxides are selected from the group consisting of Al₂O₃, CeO₂, MgO, NiO, TiO₂, V₂O₅, ZrO₂, and mixtures thereof, and/or the nitrides are selected from the group consisting of AlN, HfN, InN, MgN, NbN, SiN, TaN, TiN, ZrN, and mixtures thereof, and/or oxynitrides are selected from the group consisting of silicon oxynitride, SiOxNy, aluminum oxynitride, (AlN)ₓ · (Al₂O₃)₁₋ₓ, and mixtures thereof.

7. A method of forming a composite article comprising:
forming a composite material;
shaping the composite material into a shape of the composite article; and
forming an oxidation barrier on a surface of the composite article by atomic layer deposition.

8. The method of claim 7, wherein the composite material is a fiber reinforced polymer matrix material.

9. The method of claim 7 or 8, wherein shaping the composite material into a shape of the composite article comprises sheet molding, resin transfer molding, pre-preg layup, pulltrusion, filament winding, or mixtures thereof.

10. The method of claim 8, wherein fibers of the fiber reinforced polymer matrix material are selected from the group consisting of carbon, graphite, glass, aramid, polymer, ceramics, and mixtures thereof.

11. The method of claim 8, wherein the polymer matrix is selected from the group consisting of thermoset polymers, thermoplastic polymers, and mixtures thereof.

12. The method of claim 11, wherein the polymer matrix comprises thermoset polymers selected from the group consisting of bis-malemide, cyanate esters, epoxies, phenolics, polyesters, polyimides, polyurethanes, silicones, vinyl esters, and mixtures thereof, or wherein the polymer matrix comprises thermoplastic polymers selected from the group consisting of polyetherimide, polyamide imides, polyphenylene sulfides, polycarbonates, polyethertherketones, and mixtures thereof.

13. The method of any of claims 7 to 12, wherein the oxidation barrier comprises single material layers, single material multilayers, or multimaterial multilayers of materials selected from the group consisting of oxides, nitrides, oxynitrides, metals, and mixtures thereof.

14. The method of any of claims 7 to 13, wherein the shape of the composite article comprises ram intake manifolds, ram air exhaust manifolds, ductwork, mixing chambers, and other fluid management devices.

15. The method of any of claims 7 to 14, wherein the shape of the composite article comprises one or more components in an aircraft environmental control systems.
